Europäisches Patentamt

European Patent Office

Office européen des brevets

(11) Publication number: **0 255 968**
**A2**

(12) **EUROPEAN PATENT APPLICATION**

(21) Application number: **87201373.5**

(22) Date of filing: **17.07.87**

(51) Int. Cl.³: **H 01 L 29/06**
**H 01 L 29/91**

(30) Priority: **08.08.86 US 894403**

(43) Date of publication of application:
**17.02.88 Bulletin 88/7**

(84) Designated Contracting States:
**BE DE FR GB IT NL**

(71) Applicant: SILICONIX Incorporated
2201 Laurelwood Road
Santa Clara California 95054(US)

(72) Inventor: Blanchard, Richard A.
10724 Mora Dr.
Los Altos California 94022(US)

(74) Representative: Noz, Franciscus Xaverius, Ir. et al,
Boschdijk 155 P.O. Box 645
NL-5600 AP Eindhoven(NL)

(54) High sheet resistance polycrystalline silicone film for increasing diode breakdown voltage.

(57) A method for providing a diode comprises the step of forming a highly resistive polycrystalline silicon layer (36) over the depletion region between the anode (30) and the cathode (32). The polycrystalline silicon layer reduces the radius of curvature of the depletion region and increases the diode breakdown voltage. The highly resistive layer is formed by depositing a polycrystalline silicon layer on the diode, implanting the layer with both P and N type dopants, and heating the resulting structure. Of importance, the sheet resistivity of the polycrystalline silicon layer is dependent on the temperature at which the layer is heated. The resistivity of this layer can be controlled with great precision.

FIG._4.

EP 0 255 968 A2

-1-

# HIGH SHEET RESISTANCE POLYCRYSTALLINE SILICON
## FILM FOR INCREASING DIODE BREAKDOWN VOLTAGE

BACKGROUND

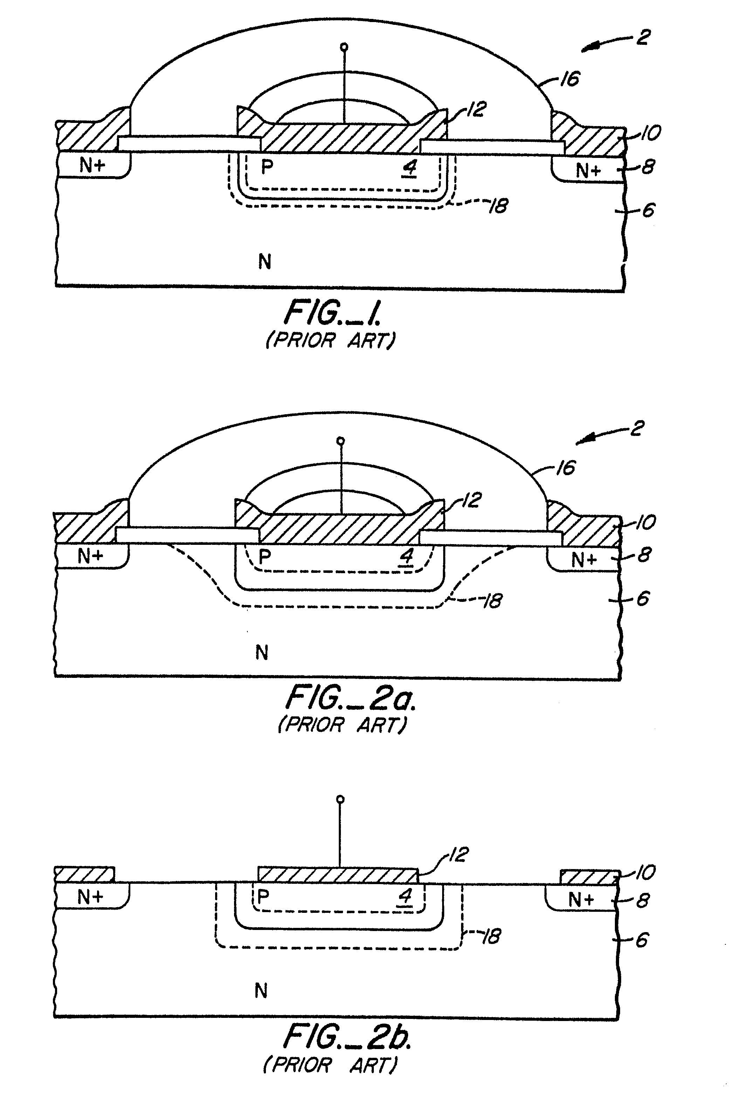

This invention relates to structures for increasing the breakdown voltage of a diode. It is known in the art to use a highly resistive film, such as a film of semi-insulating polycrystalline silicon (SIPOS) to increase the breakdown voltage of a diode. An example of such a structure is diode 2 of Figure 1. Diode 2 includes a P type region 4, which serves as an anode, formed in an N type substrate 6, which serves as a cathode. An N+ region 8 facilitates electrical connection of substrate 6 to metal 10 while P region 4 electrically contacts metal 12. A highly resistive SIPOS film 16 is provided between metal 10 and metal 12, which increases the breakdown voltage of diode 2. SIPOS film 16 alters the shape of depletion region 18 between P region 4 and N substrate 6 by reducing the radius of curvature of the depletion region. The effect of SIPOS layer 16 is shown in

Figures 2a and 2b, which illustrate the shape of depletion region 18 in the presence and absence, respectively, of SIPOS film 16 when a high reverse biased voltage is applied across the PN junction of diode 2. Because the radius of curvature of depletion region 18 is greater with SIPOS film 16 present than with SIPOS film 16 absent, the breakdown voltage of the diode of Figure 2a is greater than the breakdown voltage of the diode of Figure 2b. Other structures using SIPOS films are discussed in "Highly Reliable High-Voltage Transistors by Use of the SIPOS Process" by Matsushita, et al., published in IEEE Transactions on Electron Devices in August, 1976.

Typical SIPOS films exhibit a resistance of about $10^6$ to $10^{10}$ ohms per square, and comprise polycrystalline silicon doped with oxygen. Unfortunately, a special chemical vapor deposition (CVD) reactor is required to form a SIPOS film. Such reactors are typically dedicated to SIPOS film deposition. Further, once a SIPOS film is formed, it is impossible to adjust the resistance of that film.

It is also known in the art to form polycrystalline silicon resistors by doping polycrystalline silicon with a selected P or N type dopant. Unfortunately, it is difficult to form polycrystalline silicon films exhibiting high but precisely controlled resistance. Since films such as film 16 must be highly resistive, films provided by doping polycrystalline silicon with a P or N type dopant are not generally used to increase the breakdown voltage of diodes as described above.

SUMMARY

In accordance with this invention, a highly resistive polycrystalline silicon film is formed on a diode to increase the breakdown voltage of that diode. The polycrystalline silicon film is doped with predetermined quantities of both P type and N type dopants, such as boron and phosphorus, and heated to a predetermined temperature. By doping and heating the film appropriately, the resistivity of the film is adjusted to a desired value. Of importance, for high resistance values, the resistance of the film can be controlled with greater precision than the resistance of polycrystalline silicon doped using conventional doping processes. Further, the film can be formed with conventional semiconductor production equipment and does not require the special apparatus used to form SIPOS films.

## BRIEF DESCRIPTIONS OF THE DRAWINGS

Figure 1 illustrates in cross section a diode constructed in accordance with the prior art.

Figures 2a and 2b illustrate the depletion region in the diode of Figure 1 in the presence and absence of a SIPOS film, respectively, when a high reverse biased voltage is applied across the PN junction of the diode.

Figures 3 and 4 illustrate in cross section a diode during a manufacturing process in accordance with the invention.

Figure 5 illustrates the relationship between heating time and resistance of a polycrystalline silicon film implanted with both P and N type dopants.

## DETAILED DESCRIPTION

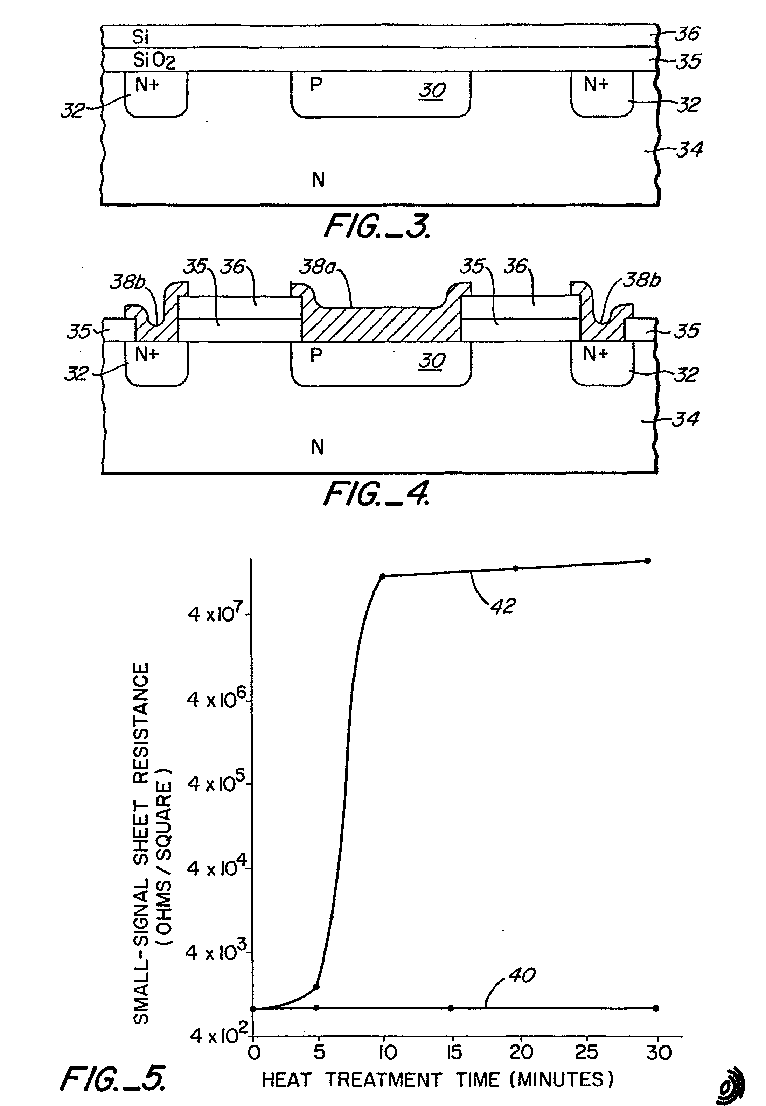

A process for forming a diode in accordance with the invention begins with the step of forming a P type anode region 30 and an N+ region 32 in an N type substrate 34 as illustrated in Figure 3. Substrate 34 is typically silicon, and regions 30 and 32 are typically formed by ion implantation or thermal predeposition followed by thermal diffusion. In one embodiment, substrate 34 is doped to a resistivity of 10 to 100 Ω-cm, region 30 is doped to a sheet resistance of 100 to 200 Ω/square, and region 32 is doped to a sheet resistance of 10 to 20 Ω/square. Substrate 34 serves as a cathode, and N+ region 32 facilitates electrical contact of substrate 34 to a subsequently formed metal layer. A silicon dioxide layer 35 is then formed on substrate 34, e.g. by thermal oxidation, and an undoped polycrystalline silicon layer 36 is formed on the silicon dioxide layer 35, e.g. by chemical vapor deposition. Polycrystalline silicon layer 36 is typically 5000 to 6000Å thick. Of importance, silicon dioxide layer 35 prevents dopants from entering polycrystalline silicon layer 36 from underlying silicon substrate 34, region 30, or region 32.

In one embodiment of the invention, polycrystalline silicon layer 36 is then processed in a manner similar to the processing discussed in "On the Semi-Insulating Polycrystalline Silicon Resistor", by Ming-Kwang Lee, et al., published in Solid State Electronics in 1984.

In such an embodiment, polycrystalline silicon layer 36 is doped with an N type dopant such as phosphorus, e.g., by ion implantation. During this process, an implantation energy of about 50 to 150 keV and a dose between approximately $10^{13}$ and $5 \times 10^{15}$ ions/cm$^2$ is used. Thereafter, the film is heated to a temperature of approximately 1000°C for 15 minutes to anneal polycrystalline silicon layer 36.

Polycrystalline silicon layer 36 is then doped with a P type dopant such as boron, e.g., by ion implantation, using a dose within the range of approximately $10^{13}$ to $5 \times 10^{15}$ ions/cm$^2$ and an implant energy of about 50 to 150 keV. Typically, the dosage of P type dopants approximately equals the dosage of N type dopants. The resistance of polycrystalline silicon layer 36 depends, in part, on the variance between the P and N type implant dosages.

Thereafter, the wafer is heated to a selected temperature (in one embodiment, 1000°C) for a selected time (e.g., 30 minutes). Of importance, the sheet resistance of polycrystalline silicon layer 36 is a function of the selected temperature and time. The higher the temperature, the greater the resistivity of polycrystalline silicon layer 36. The reasons for this phenomenon are not completely understood. However, the resistance of polycrystalline silicon layer 36 can be controlled with greater precision by varying the selected temperature than by using conventional techniques, e.g. implanting polycrystalline silicon with a dopant of a single conductivity type and controlling the resistance by varying the dosage. In the above-described embodiment, after polycrystalline silicon layer 36 is heat treated, layer 36 exhibits a sheet resistance between $4 \times 10^7$ and $8 \times 10^7$ ohms per square.

After suitable heat treatment of polycrystalline silicon layer 36, layer 36 is patterned using conventional photolithographic techniques. In addition, portions of silicon dioxide layer 35 exposed during patterning of polycrystalline silicon layer 36 are removed, thereby permitting formation of electrical contacts to the underlying semiconductor material. Metal contacts 38a and 38b are then formed on the diode (Figure 4). Metal contact 38a electrically contacts polycrystalline silicon film 36 and region 30, while metal contact 38b electrically contacts N+ region 32 and polycrystalline silicon film 36. Resulting polycrystalline silicon film 36 is typically used with diodes having breakdown voltages in excess of 500 volts.

Figure 5 illustrates the relation between heating time and sheet resistance for a polycrystalline silicon film formed using the present process. The film of Figure 5 is 5,100Å thick and doped with a dosage of $5.1 \times 10^{14}$ boron ions/cm$^2$ and $5.1 \times 10^{14}$ phosphorus ions/cm$^2$. Curve 40 illustrates the sheet resistance exhibited by the film in response to the film being heated to 450°C, and curve 42 illustrates the corresponding resistances in response to the film being heated to 1000°C. As can be seen, the resistance of the film increases by a factor of about $10^5$ in response to being heated to 1000°C for about 10 minutes. The data graphed in Figure 4 was derived from data provided in the above-incorporated paper by Ming-Kwang Lee.

It is noted that the contact between metal 38a, 38b and polycrystalline silicon 36 is resistive. In one embodiment, an N+ region is formed in the portion of polycrystalline silicon 36 directly adjacent metal 38a, 38b to mitigate the contact resistance. However, owing to the small current flowing from metal 38a to metal 38b via polycrystalline silicon 36, this is not typically necessary.

While the invention has been described regarding a specific embodiment, those skilled in the art will recognize that changes can be made in form and detail without departing from the spirit and scope of the invention. For example, a film of highly resistive polycrystalline silicon can be formed on a diode comprising an N type cathode formed in a P type substrate which serves as the anode. The above-described polycrystalline silicon film can also be formed on diodes formed in semiconductor materials other than silicon, e.g. gallium arsenide. In addition, since other high voltage semiconductor devices, e.g. transistors, SCRs, and triacs, have one PN junction requiring high voltage blocking capability, the above-described technique can be used to fabricate these high voltage semiconductor devices as well. Accordingly, all such changes come with the scope of the present invention.

## CLAIMS

1.   A method for forming a semiconductor device including a PN junction comprising the steps of:

forming a first semiconductor region of a first conductivity type within a second semiconductor region of a second conductivity type;

forming a polycrystalline semiconductor layer over at least a portion of said second semiconductor region, said polycrystalline semiconductor layer extending over the depletion region between said first and second semiconductor regions;

doping said polycrystalline semiconductor layer with an N type dopant;

doping said polycrystalline semiconductor layer with a P type dopant; and

heating said polycrystalline semiconductor layer, the resistance of said polycrystalline semiconductor layer increasing in response to said step of heating, whereby said polycrystalline semiconductor layer increases the breakdown voltage of the PN junction between said first and second semiconductor regions.

2. The method of Claim 1 wherein said P type and N type dopants are boron and phosphorus, respectively.

3. The method of Claim 1 further comprising the steps of:

forming a third semiconductor region of said second conductivity type within said second semiconductor region, said third semiconductor region having a greater dopant concentration than the dopant concentration of said second semiconductor region, said polycrystalline semiconductor layer extending over part of said third semiconductor region; and

forming a conductive layer for electrically contacting said first and third semiconductor regions.

4. The method of Claim 1 wherein said P type dopants introduced into said polycrystalline semiconductor layer have a dopant concentration approximately equal to the dopant concentration of said N type dopants.

5. A semiconductor device comprising;

a first semiconductor region of a first conductivity type;

a second semiconductor region of a second conductivity type formed within said first semiconductor region, a depletion region being formed between said first and second semiconductor regions; and

a polycrystalline semiconductor layer formed over said depletion region, said polycrystalline semiconductor layer altering the shape of said depletion region and thereby increasing the breakdown voltage of said diode, said polycrystalline semiconductor layer including both P and N type dopants.

6.    The semiconductor device of Claim 5 wherein said P and N dopants have approximately equal dopant concentrations.

7.    The semiconductor device of Claim 5 wherein said P and N dopants comprise boron and phosphorus, respectively.

0255968

**FIG._1.**
(PRIOR ART)

**FIG._2a.**
(PRIOR ART)

**FIG._2b.**
(PRIOR ART)

FIG._3.

FIG._4.

FIG._5.

HEAT TREATMENT TIME (MINUTES)